Europäisches Patentamt

European Patent Office

Office européen des brevets

(11) Veröffentlichungsnummer : **0 120 444
B1**

(12) **EUROPÄISCHE PATENTSCHRIFT**

(45) Veröffentlichungstag der Patentschrift :
17.08.88

(51) Int. Cl.⁴ : **H 03 J   9/06, H 04 B   9/00**

(21) Anmeldenummer : **84103066.1**

(22) Anmeldetag : **21.03.84**

(54) Schaltungsanordnung zur Unterdrückung von Störsignalen.

(30) Priorität : 26.03.83 DE 3311069

(43) Veröffentlichungstag der Anmeldung :
03.10.84 Patentblatt 84/40

(45) Bekanntmachung des Hinweises auf die Patenterteilung : 17.08.88 Patentblatt 88/33

(84) Benannte Vertragsstaaten :
AT BE FR GB IT LU NL SE

(56) Entgegenhaltungen :
DE-A- 2 033 824
DE-A- 2 943 913
DE-A- 3 102 256
US-A- 3 028 553

(73) Patentinhaber : Deutsche Thomson-Brandt GmbH
Hermann-Schwer-Strasse 3 Postfach 1307
D-7730 Villingen-Schwenningen (DE)

(72) Erfinder : Gleim, Günter.
Terra Wohnpark 8
D-7730 VS-Marbach (DE)
Erfinder : Baas, Dieter
Sofienstrasse 10
D-7640 Kehl (DE)

## Beschreibung

### Stand der Technik

Die Erfindung bezieht sich auf eine Schaltungsanordnung zur Unterdrückung von Störsignalen bei der Übertragung von digitalen Signalen.

Es ist bekannt, die von einem Empfänger für derartige Signale empfangenen Signale in einem Vorverstärker zu verstärken. Die verstärkten Amplituden werden darauf mit Hilfe eines RC-Gliedes gespeichert, so daß sich an diesem ein den Amplituden entsprechender Analogwert bildet. Die diesen Analogwert überragenden Digitalsignale steuern eine nachfolgende Verstärkerstufe aus. Störimpulse, die unter dem gespeicherten Wert liegen, werden dabei unterdrückt. Wenn der Abstand der Nutzimpulse unterschiedlich ist, muß die Zeitkonstante des RC-Gliedes so ausgelegt sein, daß die Signale mit den kürzeren Abständen noch übertragen werden. Das hat aber zur Folge, daß der gespeicherte analoge Wert bei größeren Impulsabständen des digitalen Signals so weit abgesunken ist, daß Störimpulse leichter durchkommen, z. B. werden digitale Signale mit unterschiedlichen Abständen, d. h. pulscodemodulierte Signale, bei der Fernbedienung von Rundfunk- und Fernsehgeräten verwendet. Die mittels Infrarotlicht als Träger ausgesendeten Signale bestehen aus mehreren seriellen kurzen Impulsen, wobei die Information, d. h. welcher Kanal der Fernsehbedienung beeinflußt werden soll, in den verschiedenen Abständen zwischen den einzelnen Impulsen liegt. Es werden auf diese Weise digitale Worte aus mehreren Bits gebildet, wobei ein großer Abstand, z. B. ein H-Signal und ein kurzer Abstand ein L-Signal bildet.

Bei den bisher bekannten Schaltungskonzepten mit Fernsteuerung von Empfangsgeräten waren einzelne Störimpulse nicht sehr kritisch, weil Prüfschaltungen einen fehlerhaft empfangenen Befehl nicht akzeptierten. Anders sieht es in der Empfängertechnik aus, wenn diese mit Mikroprozessoren ausgestattet sind, wobei der Mikroprozessor durch sein Programm hintereinander die verschiedensten Steuerungen und Überwachungen vornimmt, wie z. B. Abfrage der Fernsteuerung, Anzeige des Displays, Abstimmung und Frequenzregelung usw. Das Programm des Mikroprozessorsystems ist derart aufgestellt, daß diese die Fernsteuerbefehle bevorzugt behandelt. Es wird im Laufe des Programms immer wieder geprüft, ob ein Fernsteuerbefehl anliegt, andernfalls laufen dauernd andere Unterprogramme ab. Wenn nun starke Störimpulse vorhanden sind, wird laufend das Programm aufgerufen, so daß das Mikroprozessorsystem keine weiteren Aufgaben erfüllen kann.

In der DE-A-2 943 913 wird eine Schaltungsanordnung beschrieben, die zum Empfang von impulsförmigen Lichtsignalen mittels optoelektronischer Wandlereinrichtung dient. Der Schaltungsanordnung liegt die Aufgabe zugrunde, Störlichtanteile insbesondere in Form von Gleichlicht zu eliminieren, in Abhängigkeit des Gleichlichtanteils eine variable Schwelle zu erzeugen, so daß nur die Nutzimpulse zur Auswertung gelangen. Dazu sind am Eingang der Schaltung verschiedene Zeitkonstantenglieder vorgesehen, von denen das eine nur bei niederfrequenten Signalanteilen eine Spannung erzeugt, höherfrequente Signale werden durch einen Kondensator kurzgeschlossen. Das andere Zeitkonstantenglied bildet für die niederfrequenten Signalanteile einen Kurzschluß. Das Verhältnis der durch die Zeitkonstantenglieder geteilten Spannungen ist frequenzabhängig und nicht abhängig von der Amplitude. Bei der dort offenbarten Schaltung wird der Schwellwert weitgehend vom niederfrequent modulierten Signalanteil des durch die Empfangsdioden fließenden Stromes bestimmt jedoch nicht durch die Höhe der Signalamplitude.

Ein anschließender Komparator dient als Amplitudensieb mit einstellbarer Komparatorschwelle. Die Schwelle wird hier abhängig vom Störlichtanteil.

Zur Unterdrückung von Störimpulsen wurde eine Schaltung vorgeschlagen (DE-A-3 102 256), die sowohl bei schwachen als auch bei starken Eingangssignalen die Störimpulse unterdrückt. Diese Schaltung besitzt in ihrem Ausgangskreis eine Stufe, die bei größeren am zweiten Zeitkonstantenglied liegenden Eingangsamplituden durch eine zenerdiode eine Begrenzung des Ausgangssignals hervorruft. Die Spannung an der Ausgangsstufe kann über diesen begrenzten Wert nicht ansteigen, so daß der übrige Signalanteil an dem zweiten Zeitkonstantenglied abfällt, so daß die Amplitude des Signalpegels an dem Zeitkonstantenglied durch die Amplitude des Eingangspegels bestimmt wird.

### Aufgabe und Lösung

Der Erfindung liegt die Aufgabe zugrunde, diesen begrenzenden Effekt zu vermeiden, so daß der volle Eingangspegelhub an den Ausgang übertragen wird. Diese Aufgabe wird durch die Schaltungsanordnung mit den im Kennzeichen des Patentanspruchs angegebenen Schaltungsmaßnahmen gelöst.

Nachstehend soll an einem Ausführungsbeispiel das Wesentliche der Erfindung erläutert werden, wobei

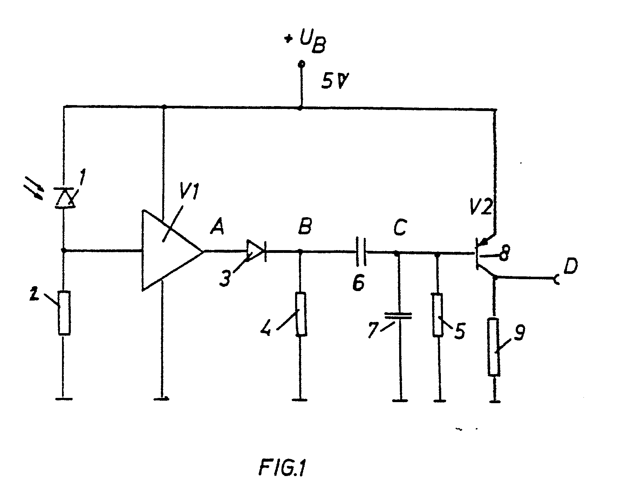

Figur 1 die Schaltungsanordnung und in

Figur 2 die an den in Figur 1 gekennzeichneten Punkten sich ergebenden Signale dargestellt sind.

Eine lichtempfindliche Diode 1 ist in Reihe zu einem Widerstand 2 zwischen eine stabilisierte Betriebsspannungsquelle UB und Bezugspotential geschaltet. Der Verbindungspunkt zwischen Diode 1 und Widerstand 2 ist an den Eingang einer ersten Verstärkerstufe V1 geschaltet. Die verstärkten Signale werden mit Hilfe einer Diode 3 gleichgerichtet und an ein erstes Zeitkonstantenglied, welches aus den Widerständen 4 und 5 und dem Kondensator 6 besteht, geschaltet. Die Signalspannung gelangt über den Kondensator 6 des ersten Zeitkonstantengliedes an das aus dem Widerstand 5 und dem Kondensator 7 gebildete zweite Zeitkonstantenglied. Die sich am Kondensator 7 ausbildende Signalspannung ist an den Eingang einer Ausgangsstufe V2 geschaltet. Der Ruhe-Gleichspannungspegel an der Basis des Transistors 8 dieser Ausgangsstufe stellt sich derart ein, daß der nicht unter die um die Basis-Emitterspannung verminderte stabilisierte Betriebsspannung sinkt, mit der der Emitter des Transistors 8 verbunden ist. Im Kollektorkreis des Transistors 8 liegt ein Kollektorwiderstand als Pull-Up-Widerstand 9, an welchem die von den Störsignalen befreite Nutzsignalspannung abgegriffen werden kann.

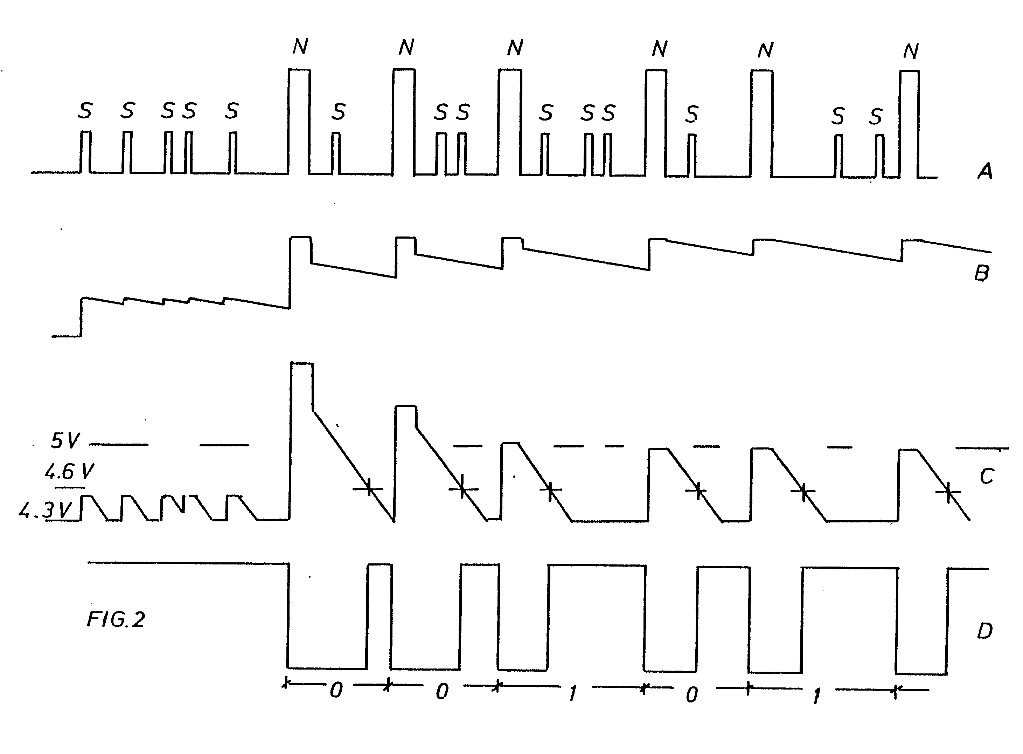

In Figur 2A sind die am Ausgang der Verstärkerstufe V1 liegenden mit den Störimpulsen S behafteten Nutzsignale N aufgetragen. Am Punkt B ergibt sich der in Figur 2B aufgezeichnete Signalverlauf. Der Spannungsverlauf am Punkt C ist in Figur 2C aufgetragen. Man erkennt, daß die Schaltschwelle der Ausgangsstufe V2 auf einen solchen Pegel gelegt wird, daß die Spitzenwerte der Störsignale S den Transistor 8 nicht in Sperrichtung vorspannen können. Erst die Nutzsignale N gelangen über die eingezeichnete Schaltschwelle, die in dem dargestellten Beispiel zwischen 4,3 Volt und Betriebsspannung UB von 5 Volt liegen kann und zwar nach Umladung des ersten Zeitkonstantengliedes 4,6. Unmittelbar nach Absinken der Spannung am Punkt C unter diese Schaltschwelle schaltet der Transistor 8 durch, so daß der Pegel am Ausgang D auf hohes Potential geschaltet wird. Die Ruhe-Gleichspannung am Punkt C kann schaltungsbedingt nicht unter 4,3 Volt absinken. Die Zeitkonstante T1 für das erste Zeitkonstantenglied ergibt sich aus dem Produkt des aus den Widerständen 4 und 5 gebildeten Gesamtwiderstandes mit dem Wert des Kondensators 6. Da der Widerstand 5 jedoch sehr klein ist gegenüber dem Widerstand 4, ergibt sich die Zeitkonstante T1 praktisch zu $T1 = R4 \times C6$. Die Zeitkonstante T2 für das zweite Zeitkonstantenglied ergibt sich zu $T2 = R5 \times C7$. Sie muß so bemessen werden, daß sie kleiner ist als der kürzeste Impulsabstand innerhalb eines Befehlswortes des Nutzsignals. Die Zeitkonstante T1 muß so groß gewählt werden, daß der Pegel am Punkt B der Schaltung zwischen zwei Worten des Befehls nicht zu weit absinken kann.

Durch die beschriebene Schaltungsanordnung wird vermieden, daß Nutzsignale mit großer Impulsdauer, die bei Vorhandensein eines stabilisierenden Elementes parallel zur Zeitkonstante T2, eine erhöhte Ladung in dem Speicherelement 6 hervorrufen würden, nicht unterdrückt (verschluckt) werden können, da die Belastung der Schaltung durch die Ausgangsstufe nur während den Impulspausen wirksam ist und somit die während eines Impulses in das Speicherelement 6 hineinfließende Ladung durch das Zeitkonstantenglied T2 bestimmt ist. Hierdurch kann die Zeitkonstante T2 des zweiten Zeitkonstantengliedes größer gewählt werden als es die Bemessungsregel nach dem kürzesten Impulsabstand vorschreibt. Auf diese Weise werden die Ausgangsimpulse verbreitert, was zur Störunterdrückung zusätzlich beiträgt.

**Patentanspruch**

Schaltungsanordnung zur Unterdrückung von Störimpulsen bei der Übertragung von digitalen Signalen unterschiedlicher zeitlicher Abstände und Amplituden mit mehreren Zeitkonstantengliedern (4, 5, 6, 7), wobei die empfangenen Signale an einen Verstärker (V1) geschaltet sind, an dessen Ausgang ein Gleichrichter (3) angeschlossen ist, der die gleichgerichtete Signalspannung über die Zeitkonstantenglieder an eine, mindestens einen Transistor (8) umfassende Ausgangsstufe (V2) schaltet, wobei die Zeitkonstante (T1) des ersten Zeitkonstantengliedes (4, 5, 6) nach dem größtem Abstand der Nutzsignale (N) bemessen wesentlich größer als die nach dem kürzesten Abständen der Nutzsignale (N) bemessenen zweiten Zeitkonstantengliedes (5, 7) ist, dadurch gekennzeichnet, daß das Zeitkonstantenglied (5, 7) mit der kleineren Zeitkonstante (T2) derart an die Ausgangsstufe (V2) angeschaltet ist, daß der an dem Zeitkonstantenglied stehende Ruhe-Gleichspannungspegel nicht unterhalb des um die Basisemitterspannung des mit seinem Emitter an die stablilisierte Betriebsspannungsquelle (U$_B$) angeschlossenen Transistors (8) der Ausgangsstufe (V2) verminderten Betriebsspannungspegels liegt und daß die von den Störsignalen befreiten Ausgangssignale an einem im Kollektorkreis des Transistors (8) geschalteten Widerstand (9) abnehmbar sind.

**Claim**

A circuit configuration for the purpose of suppressing interference pulses when transmitting digital signals of variable time spacing and amplitudes, comprizing a number of time constant elements (4, 5, 6, 7), whereby the received signals are connected to an amplifier (V1), to whose output is connected a rectifier (3), which connects the rectified signal voltage across the time constant elements to an output stage (V2), this consisting of at least one transistor (8), whereby the time constant (T1) of the first time constant element (4, 5, 6), which is dimensioned according to the greatest spacing of the useful signals (N), is appreciably greater than the time constant of the second time constant element (5, 7), this being dimensioned according to the shortest spacing of the useful signals (N), characterised in that the time constant element (5, 7) which has the smaller time constant (T2) is connected to the output stage (V2) in such a manner that the quiescent dc voltage level, which is pending on the time-constant element, does not fall below the operating voltage level that has been reduced by the base-emitter voltage of the transistor (8) in the output stage (V2), the emitter of which is connected to the stabilized operating voltage source (U_B), and that output signals that are freed of noise signals may be tapped from a resistor (9) which is included in the collector circuit of the transistor (8).

**Revendication**

Montage pour supprimer des impulsions parasites lors de la transmission de signaux numériques séparés par des intervalles de temps différents et possédant des amplitudes différentes, et comportant plusieurs circuits à constantes de temps (4, 5, 6, 7), et dans lequel les signaux reçus sont appliqués à un amplificateur (V1), à la sortie duquel est raccordé un redresseur (3) qui applique la tension de signal redressée, par l'intermédiaire des circuits à constantes de temps, à un étage de sortie (V2) contenant au moins un transistor (8), la constante de temps (T1) du premier circuit à constante de temps (4, 5, 6) étant dimensionnée, après l'intervalle maximal entre les signaux utiles (N), avec une valeur nettement plus élevée que la constante de temps du second circuit à constante de temps (5, 7), dimensionnée après les intervalles les plus courts entre les signaux utiles (N), caractérisé en ce que le circuit à constante de temps (5, 7), qui possède la plus petite constante de temps (T2), est raccordé à l'étage de sortie (V2) de telle sorte que le niveau de tension continue de repos, qui est présent au niveau du circuit à constante de temps, n'est pas inférieur au niveau de tension de fonctionnement, diminué de la tension base-émetteur du transistor (8) de l'étage de sortie (V2), raccordé par son émetteur à la source de tension stabilisée de fonctionnement (U_B), et que les signaux de sortie, dénués des signaux parasites, peuvent être prélevés sur une résistance (9) branchée dans le circuit du collecteur du transistor (8).

FIG.1

FIG.2

0 120 444